# EUROPÄISCHE PATENTSCHRIFT

(11) **EP 1 932 400 B1**
(45) Veröffentlichungstag und Bekanntmachung des Hinweises auf die Patenterteilung: **04.11.2015**
(21) Anmeldenummer: 06792843.2
(22) Anmeldetag: 16.08.2006
(51) Int. Cl.: H05K 1/02

(54) **VORRICHTUNG ZUR FEHLERSTROMERKENNUNG IN EINEM ELEKTRONISCHEN GERÄT**
APPARATUS FOR DETECTING FAULT CURRENTS IN AN ELECTRONIC DEVICE
DISPOSITIF POUR RECONNAITRE DES DEFAILLANCES DE TENSION DANS UN APPAREIL ELECTRONIQUE

(30) Priorität: 27.09.2005 DE 102005046282
(43) Veröffentlichungstag der Anmeldung: 18.06.2008
(73) Patentinhaber: ROBERT BOSCH GMBH, 70442 Stuttgart (DE)
(72) Erfinder: KNAB, Norbert, 77767 Appenweier (DE); BREITLING, Wolfram, 74343 Sachsenheim (DE)
(86) Internationale Anmeldenummer: PCT/EP2006/065362
(87) Internationale Veröffentlichungsnummer: WO 2007/036394

(56) Entgegenhaltungen:
- JP-A- 7 321 427
- US-A- 4 567 428
- US-A- 5 159 517

## Beschreibung

### Stand der Technik

Die Erfindung betrifft eine Vorrichtung zur Fehlerstromerkennung in einem elektronischen Gerät nach der Gattung des unabhängigen Anspruchs.

Insbesondere beim Einsatz in Kraftfahrzeugen ist eine Absicherung der Bordelektronik und der eingesetzten Steuergeräte vor Fehlerströmen und Kurzschlüssen sowie einer daraus resultierenden Brandgefahr von elementarer Bedeutung. Ebenso ist es erforderlich, eine durch Fehlerströme hervorgerufene Tiefenentladung einer Kraftfahrzeugbatterie zu vermeiden. Durch starke Temperatureinflüsse, die entweder von außen auf ein Steuergerät einwirken oder durch die Fehlerströme selbst hervorgerufen werden, können sich die Isolationseigenschaften der verwendeten Isolationsmaterialien für Leiterplatten oder Stanzgitterumspritzungen reduzieren, so dass die Fehlerströme ansteigen und zu einer Überhitzung bzw. Entzündung umliegender Kunststoffteile führen. Da die Fehlerströme jedoch oftmals unterhalb der Ansprechschwellen.von Kraftfahrzeugsicherungen liegen, ist ihre Erkennung und Vermeidung insbesondere bei Dauerplusleitungen durch das Auslösen der Kraftfahrzeugsicherungen sowie durch eine Trennung der Verbindung zur Batterie mittels eines Zündschlüssels nicht möglich.

Aus der US-A-5 159 517 ist ein mittels eines Steckers und zweier Versorgungsleitungen an eine Wechselspannung anschließbarer, elektrischer Verbraucher mit einem Senseleiter und einer Detektorschaltung zur Detektion eines Fehlerstroms infolge eines durch Wasser oder eine andere leitenden Flüssigkeit hervorgerufenen, niederohmigen Schlusses des elektrischen Verbrauchers bekannt. Weiterhin befindet sich im Stecker eine Unterbrecherschaltung, die im Falle eines detektierten Überstroms beide Versorgungsleitungen auftrennt. Die Detektorschaltung kann sowohl in einem Gehäuse des elektrischen Verbrauchers als auch im Stecker angeordnet sein, wobei der Senseleiter im letzteren Fall vom elektrischen Verbraucher zusammen mit den beiden Versorgungsleitungen als dritter Leiter zum Stecker geführt ist.

Aus JP 7 321427 A ist ein Vorrichtung zur Fehlerstromerkennung in einem elektronischen Gerät nach Gattung des Oberbegriffs des Anspruchs 1 bekannt.

Eine weitere, bekannte Möglichkeit zur Erkennung und Vermeidung von Fehlerströmen in Stromnetzen ergibt sich durch den Einsatz von Fehlerstromschutzschaltern, die im Fehlerfall die gesamte Energieversorgung abschalten. In Kraftfahrzeugen ist ein derartiges Vorgehen jedoch nicht möglich, da auf diese Weise gefährliche, Undefinierte Fahrzustände entstehen können. Darüber hinaus besteht hierfür auch keine Notwendigkeit, da die Kraftfahrzeugspannung in der Regel unterhalb der Sicherheitskleinspannung liegt.

### Vorteile der Erfindung

Die Erfindung betrifft eine Vorrichtung zur Fehlerstromerkennung in einem elektronischen Gerät, mit zumindest einem ersten elektrischen Leiter, der ein erstes elektrisches Potential führt, und mit einem Senseleiter, der ein elektrisches Ruhepotential aufweist, , wobei der zumindest eine erste elektrische Leiter und der Senseleiter auf und/oder in einem Isolationsmaterial voneinander beabstandet angeordnet sind, wobei mittels des Senseleiters im Fehlerfall eine Reduzierung der Isolationseigenschaften des Isolationsmaterials durch eine Verschiebung des elektrischen Ruhepotentials erkennbar ist. Erfindungsgemäß ist die Vorrichtung dadurch gekennzeichnet, dass das elektrisches Ruhepotential zwischen dem ersten elektrischen Potential und einem weiteren elektrischen Potential liegt, und wobei das elektrische Ruhepotential des Senseleiters in etwa einem Mittelwert aus dem ersten und dem weiteren elektrischen Potential entspricht, wobei ein aus mindestens einem ersten und einem zweiten Widerstand bestehender Spannungsteiler das elektrische Ruhepotential des Senseleiters in etwa auf den Mittelwert des ersten und des weiteren elektrischen Potentials legt.

Dabei vermeidet die Erkennung der veränderten Isolationseigenschaften des Isolationsmaterials vom isolierenden in einen nahezu leitenden Zustand, beispielsweise infolge von Hitzeeinwirkungen durch Fehler- und/oder Kurzschlussströme defekter, elektrischer Bauelemente und/oder Leiter, in wirkungsvoller und kostengünstiger Weise eine vollständige Batterieentladung oder eine vollkommene Zerstörung des elektronischen Geräts.

In einer alternativen Ausgestaltung ist vorgesehen, dass zumindest ein weiterer elektrischer, auf und/oder in dem Isolationsmaterial angeordneter Leiter das zumindest eine weitere elektrische Potential führt, wobei der Senseleiter, zwischen dem ersten und dem zumindest einen weiteren elektrischen Leiter beabstandet angeordnet ist. Auf diese Weise ist eine Überwachung mehrerer elektrischer Leiter mit nur einem Senseleiter in Verbindung mit einer eindeutigen Fehlererkennung sowie einer kostengünstigen Umsetzung der erfindungsgemäßen Vorrichtung gewährleistet.

Einer Auswerteschaltung ist das elektrische Ruhepotential des Senseleiters über einen Abgriff zur Überwachung der elektrischen Leiter zugeführt. Mittels eines Mikroprozessors und/oder Schwellenwertdetektors kann die Auswerteschaltung im Fehlerfall die Verschiebung des elektrischen Ruhepotentials in Richtung des ersten oder des weiteren elektrischen Potentials detektieren. Weiterhin ist die Auswerteschaltung in der Lage, zwischen einer permanenten und einer kurzzeitigen Reduzierung der Isolationseigenschaften des Isolationsmaterials zu unterscheiden und somit das elektrische Gerät im Fehlerfall ganz oder teilweise zu deaktivieren bzw. dessen Funktionsumfang einzuschränken. Darüber hinaus kann durch die Auswerteschaltung die Deaktivierung und/oder Einschränkung zeitlich begrenzt oder unbegrenzt, d.h. zum Beispiel bis zum Austausch des elektrischen Geräts, erfolgen. Alternativ oder ergänzend ist zudem vorgesehen, dass die Auswerteelektronik im Fehlerfall eine Fehlermeldung an ein übergeordnetes Steuergerät sendet, das seinerseits das elektronische Gerät über einen Steuerbefehl ganz oder teilweise deaktiviert bzw. dessen Funktionsumfang einschränkt, wobei die Deaktivierung und/oder Einschränkung auch hier zeitlich begrenzt oder unbegrenzt erfolgen kann. Um auf den Fehlerfall akustisch und/oder optisch hinzuweisen, gibt die Auswerteelektronik schließlich ein Warnsignal ab.

Die erfindungsgemäße Vorrichtung eignet sich sehr gut zur Anwendung in Verbindung mit Stanzgittern und Leiterplatten. Bei einer Stanzgitterlösung sind die elektrischen Leiter und der Senseleiter als vom Isolationsmaterial ganz oder teilweise umspritzte Stanzgitterbahnen ausgeführt, wobei es je nach Freiheitsgrad für die Gestaltung des elektrischen Geräts möglich ist, die Senseleitung gezielt an kritischen Stellen mit unterschiedlichen elektrischen Potentialen anzuordnen. Im Falle von Leiterplatten ergeben sich die elektrischen Leiter und der Senseleiter als Leiterbahnen und/oder Leiterschichten auf und/oder in der aus dem Isolationsmaterial bestehenden Leiterplatte. Auch hier können gezielt kritische Bereiche überwacht werden, in denen elektrische Leistungsbauelemente in Gestalt von Hochleistungsendstufen, Steckern oder Keramikkondensatoren ihre Anwendung finden.

Weitere Vorteile der Erfindung ergeben sich durch die in den abhängigen Ansprüchen angegebenen Merkmale sowie aus der Zeichnung und der nachfolgenden Beschreibung.

### Zeichnung

Die Erfindung wird im Folgenden anhand der Figuren 1 bis 4 beispielhaft erläutert, wobei gleiche Bezugszeichen in den Figuren auf gleiche Bestandteile mit einer gleichen Funktionsweise hindeuten. Es zeigen
Fig. 1: ein erstes Ausführungsbeispiel der erfindungsgemäßen Vorrichtung für eine Leiterplatte,
Fig. 2: ein Blockschaltbild der Beschaltung eines Senseleiters der erfindungsgemäßen Vorrichtung,
Fig. 3: ein zweites Ausführungsbeispiel der erfindungsgemäßen Vorrichtung für ein Stanzgitter und
Fig. 4: ein drittes Ausführungsbeispiel der erfindungsgemäßen Vorrichtung für eine mehrschichtige Leiterplatte.

### Beschreibung

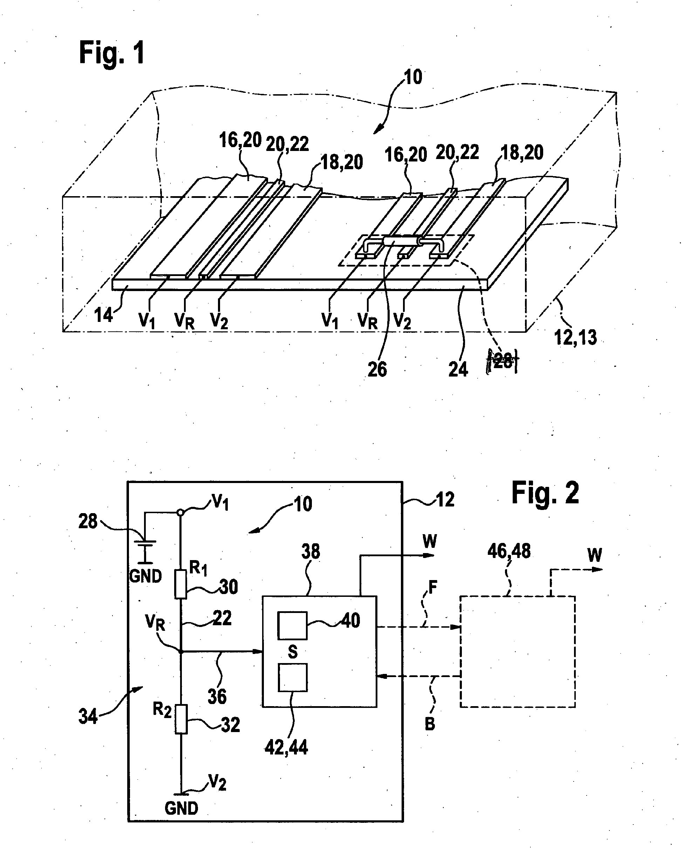

Figur 1 zeigt ein erstes Ausführungsbeispiel der erfindungsgemäßen Vorrichtung 10 zur Fehlerstromerkennung in einem elektronischen Gerät 12, das beispielsweise als ein Kraftfahrzeug-Steuergerät 13 eines nicht dargestellten Kraftfahrzeugs ausgebildet sein kann. Auf einer Leiterplatte 14 (Printed Circuit Board - PCB) sind ein erster elektrischer Leiter 16 und ein zweiter elektrischer Leiter 18 als Leiterbahnen 20 ausgeführt. Der erste elektrische Leiter 16 ist mit einem ersten elektrischen Potential V₁ beaufschlagt, während dem zweiten elektrischen Leiter ein zweites elektrisches Potential V₂ zugeführt ist. Zwischen den beiden elektrischen Leitern 16 und 18 ist ein ebenfalls als Leiterbahn 20 ausgeführter Senseleiter 22 angeordnet, der ein elektrisches Ruhepotential V_{R} aufweist, das zwischen dem ersten elektrischen Potential V₁ und dem zweiten elektrischen Potential V₂ liegt. In vorteilhafter Weise ergibt sich das elektrische Ruhepotential V_{R} in etwa aus dem arithmetischen Mittelwert (ebenso sind auch andere Mittelwertbildungen, wie ein geometrischer Mittelwert denkbar) des ersten und des zweiten elektrischen Potentials V₁ bzw. V₂, wobei die Bezeichnung "in etwa" andeuten soll, dass eine exakte Einhaltung des Mittelwertes nicht unbedingt erforderlich ist, da ein gewisser Unschärfebereich zur Erkennung der Fehlerströme zugelassen werden kann. Statt des Mittelwerts kann aber auch - wie später noch in Verbindung mit Figur 2 gezeigt - ein anderes Ruhepotential V_{R} am Senseleiter angelegt werden. Die in Figur 1 gezeigten Markierungslinien zwischen den elektrischen Potentialen V₁, V₂ und V_{R} und den elektrischen Leitern 16, 18 und 22 können sowohl als tatsächlich existierende Verbindungsleitungen als auch als reine Bezugszeichenmarkierungen verstanden werden. Im letzteren Fall dienen sie daher nur zur Verdeutlichung, an welchem elektrischen Leiter welches elektrische Potential anliegt.

Da die Leiterbahnen 20 der elektrischen Leiter 16 und 18 unterschiedliche Potentiale V₁ und V₂ aufweisen, muss ein niederohmiger Schluss zwischen ihnen durch die Verwendung eines Isolationsmaterials 24, beispielsweise Pertinax, für die Leiterplatte 14 vermieden werden. Infolge externer oder interner Hitzeeinwirkungen, wobei letztere beispielsweise durch Quer- bzw. Fehlerströme zwischen den Leiterbahnen 20 oder durch Leistungsbauelemente 26 in entsprechenden kritischen Bereichen der Leiterplatte 14 hervorgerufen werden können, besteht die Gefahr, dass sich die Isolationseigenschaften des Isolationsmaterials 24 verringern. Dies wiederum führt zu erhöhten Fehlerströmen, die eine vollständige Batterieentladung oder eine thermische Beeinflussung des elektrischen Geräts 12 bis hin zu dessen Zerstörung zur Folge haben können, da insbesondere bei einer Dauerplusverbindung des ersten Leiters 16 mit dem Pluspol einer in Figur 2 gezeigten Batterie 28 keine Auftrennung durch einen Fahrzeugschlüssel möglich ist. Zudem liegen die Fehlerströme oftmals unterhalb der Ansprechschwelle von Kraftfahrzeugsicherungen, so dass auch diese keine ausreichende Absicherung gewährleisten können.

Mit Hilfe des Senseleiters 22, der zwischen den beiden elektrischen Leitern 16 und 18 beabstandet auf dem Isolationsmaterial 24 angeordnet ist, kann nun eine Reduzierung der Isolationseigenschaften des Isolationsmaterials 24 durch eine Verschiebung des elektrischen Ruhepotentials V_{R} in Richtung des ersten oder des zweiten elektrischen Potentials V₁ bzw. V₂ erkannt werden. Entsprechendes gilt für den kritischen Bereich der Leiterplatte 14, in dem Leistungsbauelemente 26, wie zum Beispiel Endstufentransistoren, Keramikkondensatoren, Steckkontakte oder dergleichen eingesetzt werden. Selbstverständlich kann der Senseleiter 22 auch nur in Verbindung mit einem einzigen, ersten elektrischen Leiter 16 zum Einsatz kommen, wobei das Ruhepotential V_{R} in diesem Fall zwischen dem ersten elektrischen Potential V₁ des ersten elektrischen Leiters 16 und einem Bezugspotential, beispielsweise einem Massepotential GND, liegen sollte. In diesem Fall wird eine Reduzierung der Isolationseigenschaften des Isolationsmaterial 24 erkannt, wenn sich das Ruhepotential V_{R} des zum ersten elektrischen Leiter 16 beabstandet angeordneten Senseleiters 22 in Richtung des ersten elektrischen Potentials V₁ verschiebt.

In Figur 2 ist das Blockschaltbild einer Beschaltung des Senseleiters 22 gezeigt. Zur Beaufschlagung des Senseleiters 22 mit dem Ruhepotential V_{R} wird ein aus einem ersten und einem zweiten Widerstand 30 bzw. 32 bestehender Spannungsteiler 34 derart mit dem Senseleiter 22 verschaltet, dass er zwischen den beiden Widerständen 30 und 32 liegt, wobei der erste Widerstand 30 am ersten elektrischen Potential V₁ und der zweite Widerstand 32 am zweiten elektrischen Potential V₂ angeschlossen ist. Weisen beide Widerstände 30 und 32 identische Widerstandswerte R₁ bzw. R₂ auf, so ergibt sich automatisch ein Ruhepotential V_{R}, das dem arithmetischen Mittelwert aus dem ersten und dem zweiten elektrischen Potential V₁ bzw. V₂ entspricht. Entspricht das erste elektrische Potential V₁ einem Versorgungspotential V_{Batt} der Batterie 28 und das zweite elektrische Potential V₂ dem Massepotential GND, so stellt sich beispielsweise ein Ruhepotential V_{R} = V_{Batt}/2 ein. Soll die Fehlerstromerkennung statt vom arithmetischen Mittelwerte vom geometrischen Mittelwert oder einem anderen Ruhestromwert ausgehen, so ist es alternativ natürlich ebenso möglich, die Widerstandswerte R₁ und R₂ unterschiedlich groß zu wählen. Im Folgenden soll jedoch weiterhin von gleich großen Widerstandswerten R₁ und R₂ ausgegangen werden. Es sei noch angemerkt, dass die Widerstände 30 und 32 auch durch entsprechend in Reihe oder parallel geschaltete Widerstandspakete realisiert werden können.

Über einen Abgriff 36 ist der Senseleiter 22 mit einer Auswerteelektronik 38 des elektrischen Geräts 12 verbunden, wobei die Auswerteelektronik 38 einen Mikroprozessor 40 und/oder einen Schwellenwertdetektor 42, beispielsweise in Gestalt eines Komparators 44, umfasst. Die Auswerteelektronik 38 überwacht das Ruhepotential V_{R} des Senseleiters 22 und vergleicht dieses in definierten Zeitabständen (zyklisch oder ereignisabhängig) mit einem Schwellenwert bzw. einem Schwellenwertfenster S. Der Schwellenwert bzw. das Schwellenwertfenster S ergibt sich im Falle identischer Widerstandswerte R₁ und R₂ beispielsweise zu S = (V₁ + V₂)/2 bzw. S = (V₁ + V₂)/2 ± U, wobei U einen zulässigen Unschärfebereich definiert. Sind R₁ und R₂ unterschiedlich groß, so berechnet sich S zu S = (R₂ /(R₁ + R₂)) · (V₁ + V₂) - V₂ ± U. Für das in Figur 2 gezeigte Ausführungsbeispiel ergibt sich so mit V₁ = V_{Batt} und V₂ = 0 (GND) ein Schwellenwert von S = V_{Batt}/2. Alternativ bzw. ergänzend ist es ebenso möglich, dass das Ruhepotential V_{R} im fehlerfreien Betrieb des elektrischen Geräts 12 gemessen und als Schwellenwert S gesetzt wird.

Ergibt sich nun im Fehlerfall, dass das in den definierten Zeitabständen gemessene Ruhepotential V_{R} vom Schwellenwert S in Richtung des ersten oder des zweiten elektrischen Potentials V₁ bzw. V₂ abweicht, so schließt die Auswerteelektronik 38 auf eine Reduzierung der Isolationseigenschaften des Isolationsmaterials 24. Dabei ist die Auswerteelektronik 38 in der Lage, zwischen einer kurzzeitigen, d.h. nicht oder nur geringfügig bedrohlichen und einer permanenten, d.h. bedrohlichen Reduzierung zu unterscheiden. In Abhängigkeit von dem Resultat deaktiviert die Auswerteelektronik 38 nun das elektronische Gerät 12 ganz oder teilweise bzw. schränkt dessen Funktionsumfang beispielsweise durch gezielte Stilllegung kritischer Bereiche ein, wobei die Deaktivierung und/oder Einschränkung zeitlich begrenzt oder unbegrenzt erfolgen kann. Diesbezüglich ist unter zeitlich unbegrenzt beispielsweise die Zeitspanne bis zum Austausch des defekten, elektronischen Geräts 12 in einer Fachwerkstatt zu verstehen. Zu diesem Zweck ist die Auswerteelektronik 38 in der Lage, zur akustischen und/oder optischen Anzeige des detektierten Fehlerfalls ein Warnsignal W an eine nicht gezeigte Anzeigevorrichtung abzugeben.

Weiterhin kann vorgesehen sein, dass die Auswerteelektronik 38 des elektrischen Geräts 12 im detektierten Fehlerfall eine Fehlermeldung F an ein übergeordnetes Steuergerät 46, zum Beispiel ein Master-Steuergerät 48 in einer Master-Slave-Anordnung, sendet. Das übergeordnete Steuergerät 46 deaktiviert dann das elektrische Gerät 12 über einen Steuerbefehl B ganz oder teilweise bzw. schränkt dessen Funktionsumfang ein, wobei auch hier die Deaktivierung und/oder Einschränkung zeitlich begrenzt oder unbegrenzt erfolgen kann. Ebenso wie die Auswerteelektronik 38 des elektrischen Geräts 12 kann auch das übergeordnete Steuergerät 48 das Warnsignal W abgeben.

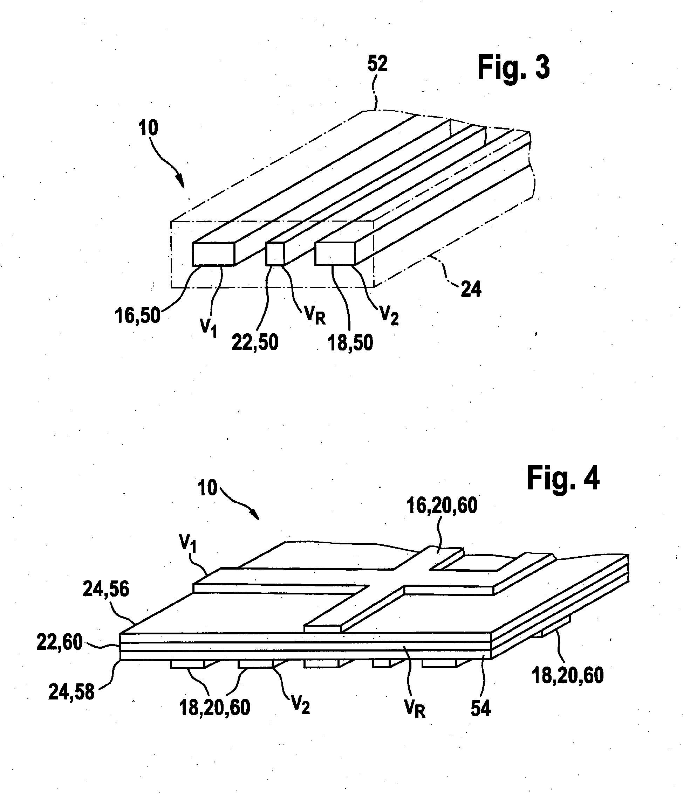

Figur 3 zeigt eine zweite Ausführungsform der erfindungsgemäßen Vorrichtung 10, wobei hier aus Übersichtlichkeitsgründen auf die Darstellung des elektrischen Geräts 12 verzichtet wurde. Im Unterschied zu Figur 1 sind der erste und der zweite elektrische Leiter 16 bzw. 18 sowie der Senseleiter 22 nun als Stanzgitterbahnen 50 eines Stanzgitters 52 ausgebildet und von dem Isolationsmaterial 24 ganz oder teilweise umspritzt. Auch hier weisen der erste elektrische Leiter 16 das erste elektrische Potential V₁, der zweite elektrische Leiter 18 das zweite elektrische Potential V₂ und der Senseleiter 22 das elektrische Ruhepotential V_{R} auf. Da die Beschaltung des Senseleiters 22 und die Überwachung der Isolationseigenschaften des Isolationsmaterials 24 derjenigen in Figur 1 bzw. Figur 2 entspricht, soll im Folgenden auf deren erneute Beschreibung verzichtet werden.

In Figur 4 ist eine dritte Ausführungsform der erfindungsgemäßen Vorrichtung 10 dargestellt, wobei im Unterschied zu Figur 1 nun eine mehrschichtige Leiterplatte 54 (Multilayer) mit einem in zwei Isolationsschichten 56 bzw. 58 ausgeführten Isolationsmaterial 24 zum Einsatz kommt. Die beiden Isolationsschichten 56 und 58 des Isolationsmaterials tragen jeweils einen der als Leiterbahnen 20 und/oder Leiterschichten 60 ausgebildeten elektrischen Leiter 16 und 18 und sind durch den ebenfalls als Leiterschicht 60 ausgebildeten Senseleiter 22 in Gestalt einer Sandwich-Struktur voneinander getrennt. Der Senseleiter 22 ist entsprechend Figur 2 beschaltet, so dass hierauf im Folgenden nicht näher eingegangen werden soll. Selbstverständlich kann die mehrschichtige Leiterplatte 54 ohne Einschränkung der Erfindung auch deutlich mehr Leiterbahnen 20 bzw. Leiterschichten 60 mit unterschiedlichen Potentialen aufweisen. Der Übersichtlichkeit halber wurde jedoch auf die Darstellung eines entsprechend aufwändigen Ausführungsbeispiels verzichtet.

Kommt es nun im Fehlerfall zu einer Reduzierung der Isolationseigenschaften der ersten oder zweiten Isolationsschicht 56 bzw. 58, so verschiebt sich das Ruhepotential V_{R} des Senseleiters 22 in Richtung des ersten oder des zweiten elektrischen Potentials V₁ bzw. V₂. Demzufolge kann in analoger Weise zu Figur 1 auch hier eine Fehlerstromerkennung entsprechend der obigen Beschreibung zu Figur 2 erfolgen.

Es sei abschließend noch darauf hingewiesen, dass die gezeigten Ausführungsbeispiel weder auf die Figuren 1 bis 4 noch auf eine Anwendung im Kraftfahrzeugbereich beschränkt ist. So können beispielsweise sämtliche elektronischen Geräte überwacht werden, die entsprechende Isolationsmaterialen in Verbindung mit Leiterplatten und/oder Stanzgittern aufweisen.

## Patentansprüche

1. Vorrichtung (10) zur Fehlerstromerkennung in einem elektronischen Gerät (12), mit zumindest einem ersten elektrischen Leiter (16), der ein erstes elektrisches Potential (V₁) führt, und mit einem Senseleiter (22), der ein elektrisches Ruhepotential (V_{R}) aufweist, wobei der zumindest eine erste elektrische Leiter (16) und der Senseleiter (22) auf und/oder in einem Isolationsmaterial (24) voneinander beabstandet angeordnet sind, wobei mittels des Senseleiters (22) im Fehlerfall eine Reduzierung der Isolationseigenschaften des Isolationsmaterials (24) durch eine Verschiebung des elektrischen Ruhepotentials (V_{R}) erkennbar ist **dadurch gekennzeichnet, dass** das elektrisches Ruhepotential (V_{R}) zwischen dem ersten elektrischen Potential (V₁) und einem weiteren elektrischen Potential (V₂) liegt, und wobei das elektrische Ruhepotential (V_{R}) des Senseleiters (22) in etwa einem Mittelwert aus dem ersten (V₁) und dem weiteren elektrischen Potential (V₂) entspricht, wobei ein aus mindestens einem ersten (30) und einem zweiten Widerstand (32) bestehender Spannungsteiler (34) das elektrische Ruhepotential (V_{R}) des Senseleiters (22) in etwa auf den Mittelwert des ersten (V₁) und des weiteren elektrischen Potentials (V₂) legt.

2. Vorrichtung (10) nach Anspruch 1, **dadurch gekennzeichnet, dass** zumindest ein weiterer elektrischer, auf und/oder in dem Isolationsmaterial (24) angeordneter Leiter (18) das zumindest eine weitere elektrische Potential (V₂) führt, wobei der Senseleiter (22), zwischen dem ersten (16) und dem zumindest einen weiteren elektrischen Leiter (18) beabstandet angeordnet ist.

3. Vorrichtung (10) nach einem der vorhergehenden Ansprüche, **gekennzeichnet durch** eine Auswerteelektronik (38), der das elektrische Ruhepotential (V_{R}) des Senseleiters (22) über einen Abgriff (36) zur Überwachung zugeführt ist.

4. Vorrichtung (10) nach Anspruch 3, **dadurch gekennzeichnet, dass** die Auswerteelektronik (38) zwischen einer permanenten und einer kurzzeitigen Reduzierung der Isolationseigenschaften des Isolationsmaterials (24) unterscheidet.

5. Vorrichtung (10) nach einem der Ansprüche 3 oder 4, **dadurch gekennzeichnet, dass** die Auswerteelektronik (38) das elektronische Gerät (12) im Fehlerfall ganz oder teilweise deaktiviert bzw. dessen Funktionsumfang einschränkt, wobei die Deaktivierung und/oder Einschränkung zeitlich begrenzt oder unbegrenzt erfolgen kann.

6. Vorrichtung (10) nach einem der Ansprüche 3 oder 4 **dadurch gekennzeichnet, dass** die Auswerteelektronik (38) im Fehlerfall eine Fehlermeldung (F) an ein übergeordnetes Steuergerät (46) sendet, das seinerseits das elektronische Gerät (12) über einen Steuerbefehl (B) ganz oder teilweise deaktiviert bzw. dessen Funktionsumfang einschränkt, wobei die Deaktivierung und/oder Einschränkung zeitlich begrenzt oder unbegrenzt erfolgen kann.

7. Vorrichtung (10) nach einem der vorhergehenden Ansprüche, **dadurch gekennzeichnet, dass** die Auswerteelektronik (38) einen Mikroprozessor (40) und/oder einen Schwellenwertdetektor (42) umfasst, die im Fehlerfall eine Verschiebung des elektrischen Ruhepotentials (V_{R}) in Richtung des ersten (V₁) oder des weiteren elektrischen Potentials (V₂) detektieren.

8. Vorrichtung (10) nach einem der vorhergehenden Ansprüche, **dadurch gekennzeichnet, dass** die Auswerteelektronik (38) im Fehlerfall ein Warnsignal (W) zur akustischen und/oder optischen Anzeige des Fehlerfalls abgibt.

9. Vorrichtung (10) nach einem der vorhergehenden Ansprüche, **dadurch gekennzeichnet, dass** die elektrischen Leiter (16, 18) und der Senseleiter (22) vom Isolationsmaterial (24) ganz oder teilweise umspritzte Stanzgitterbahnen (50) eines Stanzgitters (52) sind.

10. Vorrichtung (10) nach einem der vorhergehenden Ansprüche, **dadurch gekennzeichnet, dass** die elektrischen Leiter (16, 18) und/oder der Senseleiter (22) Leiterbahnen (20) und/oder Leiterschichten (60) auf und/oder in einer aus dem Isolationsmaterial (24) bestehenden Leiterplatte (14, 54) sind.

11. Vorrichtung (10) nach einem der vorhergehenden Ansprüche, **dadurch gekennzeichnet, dass** der Senseleiter (22) zur Überwachung des Isolationsmaterials (24) im kritischen Bereich elektrischer Leistungsbauelemente (26) angeordnet ist.

12. Vorrichtung (10) nach einem der vorhergehenden Ansprüche, **dadurch gekennzeichnet, dass** das erste elektrische Potential (V₁) ein Versorgungspotential (V_{Batt}) und das weitere elektrische Potential (V₂) ein Massepotential (GND) einer Batterie (28) ist.

13. Vorrichtung (10) nach einem der vorhergehenden Ansprüche, **dadurch gekennzeichnet, dass** das elektronische Gerät (12) ein Kraftfahrzeug-Steuergerät (13) ist.

## Claims

1. Apparatus (10) for fault current detection in an electronic device (12), comprising at least one first electrical conductor (16), which conducts a first electrical potential (V₁), and comprising a sense conductor (22), which has an electrical open-circuit potential (V_{R}), wherein the at least one first electrical conductor (16) and the sense conductor (22) are arranged spaced apart from one another on and/or in an insulation material (24), wherein, in the event of a fault, a reduction in the insulation properties of the insulation material (24) can be detected by a shift in the electrical open-circuit potential (V_{R}) by means of the sense conductor (22), **characterized in that** the electrical open-circuit potential (V_{R}) is between the first electrical potential (V₁) and a further electrical potential (V₂), and wherein the electrical open-circuit potential (V_{R}) of the sense conductor (22) approximately corresponds to an average value of the first electrical potential (V₁) and the further electrical potential (V₂), wherein a voltage divider (34) consisting of at least one first resistor (30) and one second resistor (32) applies the electrical open-circuit potential (V_{R}) of the sense conductor (22) approximately to the average value of the first electrical potential (V₁) and the further electrical potential (V₂).

2. Apparatus (10) according to Claim 1, **characterized in that** at least one further electrical conductor (18), which is arranged on and/or in the insulation material (24), conducts at least one further electrical potential (V₂), wherein the sense conductor (22) is arranged, spaced apart, between the first electrical conductor (16) and the at least one further electrical conductor (18).

3. Apparatus (10) according to one of the preceding claims, **characterized by** evaluation electronics (38), to which the electrical open-circuit potential (V_{R}) at the sense conductor (22) is supplied via a tap (36) for monitoring purposes.

4. Apparatus (10) according to Claim 3, **characterized in that** the evaluation electronics (38) decide between a permanent and a temporary reduction in the insulation properties of the insulation material (24).

5. Apparatus (10) according to either of Claims 3 and 4, **characterized in that** the evaluation electronics (38) entirely or partially deactivate the electronic device (12) in the event of a fault or restrict the functional extent thereof, wherein the deactivation and/or restriction can take place in temporally limited or unlimited fashion.

6. Apparatus (10) according to either of Claims 3 and 4, **characterized in that** the evaluation electronics (38) transmit a fault message (F) to a superordinate control device (46) in the event of a fault, said control device for its part entirely or partially deactivating the electronic device (12) via a control command (B) or restricting the functional extent thereof, wherein the deactivation and/or restriction can take place in temporally limited or unlimited fashion.

7. Apparatus (10) according to one of the preceding claims, **characterized in that** the evaluation electronics (38) comprise a microprocessor (40) and/or a threshold value detector (42), which detect a shift in the electrical open-circuit potential (V_{R}) in the direction of the first electrical potential (V₁) or the further electrical potential (V₂) in the event of a fault.

8. Apparatus (10) according to one of the preceding claims, **characterized in that**, in the event of a fault, the evaluation electronics (38) emit a warning signal (W) for acoustically and/or optically displaying the fault event.

9. Apparatus (10) according to one of the preceding claims, **characterized in that** the electrical conductors (16, 18) and the sense conductor (22) are leadframe tracks (50) of a leadframe (52) which are entirely or partially encapsulated by injection moulding with the insulation material (24).

10. Apparatus (10) according to one of the preceding claims, **characterized in that** the electrical conductors (16, 18) and/or the sense conductor (22) are conductor tracks (20) and/or conductor layers (60) on and/or in a printed circuit board (14, 54) consisting of insulation material (24).

11. Apparatus (10) according to one of the preceding claims, **characterized in that** the sense conductor (22), for monitoring of the insulation material (24), is arranged in the critical region of electrical power components (26).

12. Apparatus (10) according to one of the preceding claims, **characterized in that** the first electrical potential (V₁) is a supply potential (V_{Batt}) and the further electrical potential (V₂) is a ground potential (GND) of a battery (28).

13. Apparatus (10) according to one of the preceding claims, **characterized in that** the electronic device (12) is a motor vehicle control device (13).

## Revendications

1. Dispositif (10) de détection du courant de défaut dans un appareil électronique (12), comprenant au moins un premier conducteur électrique (16) qui conduit un premier potentiel électrique (V₁) et comprenant un conducteur de détection (22) qui possède un potentiel électrique de repos (V_{R}), l'au moins un premier conducteur électrique (16) et le conducteur de détection (22) étant disposés sur et/ou dans un matériau isolant (24) espacés l'un de l'autre, une réduction des propriétés isolantes du matériau isolant (24) pouvant être détectée par le conducteur de détection (22) en cas de défaut par un décalage du potentiel électrique de repos (V_{R}), **caractérisé en ce que** le potentiel électrique de repos (V_{R}) se trouve entre le premier potentiel électrique (V₁) et un potentiel électrique supplémentaire (V₂), et le potentiel électrique de repos (V_{R}) du conducteur de détection (22) correspondant approximativement à une valeur moyenne du premier (V₁) et du potentiel électrique supplémentaire (V₂), un diviseur de tension (34), constitué d'au moins une première (30) et une deuxième résistance (32), amenant le potentiel électrique de repos (V_{R}) du conducteur de détection (22) approximativement à la valeur moyenne du premier (V₁) et du potentiel électrique supplémentaire (V₂).

2. Dispositif (10) selon la revendication 1, **caractérisé en ce qu'**au moins un conducteur électrique supplémentaire (18), disposé sur et/ou dans le matériau isolant (24), conduit l'au moins un potentiel électrique supplémentaire (V₂), le conducteur de détection (22) étant disposé de manière espacée entre le premier (16) et l'au moins un conducteur électrique supplémentaire (18).

3. Dispositif (10) selon l'une des revendications précédentes, **caractérisé par** une électronique d'interprétation (38) à laquelle le potentiel électrique de repos (V_{R}) du conducteur de détection (22) est acheminé par le biais d'une prise (36) à des fins de surveillance.

4. Dispositif (10) selon la revendication 3, **caractérisé en ce que** l'électronique d'interprétation (38) fait la différence entre une réduction permanente et de courte durée des propriétés isolantes du matériau isolant (24).

5. Dispositif (10) selon l'une des revendications 3 ou 4, **caractérisé en ce que** l'électronique d'interprétation (38), en cas de défaut, désactive totalement ou partiellement l'appareil électronique (12) ou restreint l'étendue de ses fonctions, la désactivation et/ou la restriction pouvant être effectuées de manière limitée ou illimitée dans le temps.

6. Dispositif (10) selon l'une des revendications 3 ou 4, **caractérisé en ce que** l'électronique d'interprétation (38), en cas de défaut, envoie un message d'erreur (F) à un contrôleur (46) de niveau supérieur qui, de son côté, désactive totalement ou partiellement l'appareil électronique (12) ou restreint l'étendue de ses fonctions par le biais d'une instruction de commande (B), la désactivation et/ou la restriction pouvant être effectuées de manière limitée ou illimitée dans le temps.

7. Dispositif (10) selon l'une des revendications précédentes, **caractérisé en ce que** l'électronique d'interprétation (38) comprend un microprocesseur (40) et/ou un détecteur de valeur de seuil (42) qui, en cas de défaut, détectent un décalage du potentiel électrique de repos (V_{R}) en direction du premier (V₁) ou du potentiel électrique supplémentaire (V₂).

8. Dispositif (10) selon l'une des revendications précédentes, **caractérisé en ce que** l'électronique d'interprétation (38), en cas de défaut, émet un signal d'alerte (W) en vue de signaler la situation de défaut de manière sonore et/ou visuelle.

9. Dispositif (10) selon l'une des revendications précédentes, **caractérisé en ce que** les conducteurs électriques (16, 18) et le conducteur de détection (22) sont les pistes de grille estampée (50) totalement ou partiellement surmoulées du matériau isolant (24) d'une grille estampée (52).

10. Dispositif (10) selon l'une des revendications précédentes, **caractérisé en ce que** les conducteurs électriques (16, 18) et/ou le conducteur de détection (22) sont des pistes conductrices (20) et/ou des couches conductrices (60) sur et/ou dans un circuit imprimé (14, 54) constitué du matériau isolant (24).

11. Dispositif (10) selon l'une des revendications précédentes, **caractérisé en ce que** le conducteur de détection (22), en vue de surveiller le matériau isolant (24), est disposé dans la zone critique de composants électriques de puissance (26).

12. Dispositif (10) selon l'une des revendications précédentes, **caractérisé en ce que** le premier potentiel électrique (V₁) est un potentiel d'alimentation (V_{Batt}) et le potentiel électrique supplémentaire (V₂) est un potentiel de masse (GND) d'une batterie (28).

13. Dispositif (10) selon l'une des revendications précédentes, **caractérisé en ce que** l'appareil
électronique (12) est un contrôleur de véhicule automobile (13).
